# EUROPEAN PATENT SPECIFICATION

(11) **EP 3 044 343 B1**
(45) Date of publication and mention of the grant of the patent: **26.12.2018**
(21) Application number: 14766647.3
(22) Date of filing: 10.09.2014
(51) Int. Cl.: C22C 5/02

(54) **CRYSTALLINE GOLD ALLOYS WITH IMPROVED HARDNESS**
KRISTALLINE GOLDLEGIERUNGEN MIT VERBESSERTER HÄRTE
ALLIAGES D'OR CRISTALLIN À DURETÉ AMÉLIORÉE

(30) Priority: 10.09.2013 US 201361876163 P; 30.05.2014 US 201462005366 P; 09.09.2014 US 201462047718 P
(43) Date of publication of application: 20.07.2016
(73) Proprietor: Apple Inc., Cupertino CA 95014 (US)
(72) Inventor: FEINBERG, Zechariah D., Cupertino, California 95014 (US); WRIGHT, James A., Cupertino, California 95014 (US)
(74) Representative: Froud, Christopher Andrew
(86) International application number: PCT/US2014/054974
(87) International publication number: WO 2015/038636

(56) References cited:
- WO-A1-2012/053640
- GB-A- 1 197 778
- JP-A- H0 533 085
- US-A- 2 127 676
- US-A- 2 304 416
- US-A1- 2006 029 513
- US-A1- 2012 312 428

## Description

### FIELD

The present invention relates to gold alloys. More specifically, the embodiments relate to gold alloys with improved strength and hardness for applications including enclosures for electronic devices.

### BACKGROUND

Commercial gold alloys, such as the 18 karat gold (Au) alloy, have relatively low yield strength and low hardness (e.g. about 130-150 Vickers). Some gold alloys have been developed to have improved hardness of about 240-250 Vickers, but are still less than 300 Vickers. For example, U.S. Patent No. 6,406,568 discloses 18-karat green gold alloys containing Au-Ag-Cu-Zn that are capable of being aged-hardened to a hardness of about 240 Vickers (VHN). U.S. Patent Publication No. 2013/0153097 discloses 18 karat Au-Al gold alloys with a hardness less than 300 VHN. The alloys have improved hardness by forming Al₂Au₅ precipitates GB 1 197 778 discloses gold alloys for jewelry which is easily polished and has a fine grain structure.

With a hardness lower than 300 VHN, the gold alloys may not be durable or may not have adequate scratch resistance for use as enclosures for electronic devices, including mobile phones, tablet computers, notebook computers, instrument windows, appliance screens, and the like. It may be desirable to have alloys with improved yield strength and hardness such that the alloys do not dent easily and have improved scratch resistance and durability.

Generally, gold alloys can have different colors, such as yellow gold, red gold, rose gold, pink gold, white gold, gray gold, green gold, blue gold, or purple gold. The gold alloy composition varies with the color. Some colors, such as yellow gold, pink gold, or rose gold, may be cosmetically appealing to consumers for use as enclosures for electronic devices. JP0533085A discloses gold alloys having red and pink colors comprising 70 to 80% Au, 3 to 11% Ag, 9 to 25% Cu and 0.1 to 1% Zn. US2006029513 describes alloys containing 10 to 20,000 ppm Zn, 10 to 20,000 ppm Ga, 10 to 10,000 ppm Ta, 10 to 10,000 ppm Pt, 10 to 5,000 ppm Ru in a gold alloy of at least 14 carats. WO 2012/053640 describes a gold clay gold and oxide powder containing copper, a binder and water.

### SUMMARY

The gold alloy of the invention is given in claim 1, with the preferred embodiment given in claim 2.

Embodiments described herein may provide gold alloys with improved strength and hardness of at least 280, 290, or 300 Vickers. The alloys provide yellow gold color and rose gold color. The alloys also provide good surface finish after polishing.

In various examples, the alloys described herein have equiaxed grains having mean lengths that are less than 40 microns. In further embodiments, the alloys described herein have equiaxed grains having mean lengths that are less than 30 microns. Such alloys are more resistant to cracking due to finer grain sizes.
The invention provides a gold alloy as defined in the claims

It will be understood to those of skill in the art that the alloys disclosed herein that all elements total to 100 wt%.

In one embodiment, the gold alloy includes 75-79 wt% Au, Ag, Cu, and at least one of Co, Ir, and Ru.

In a particular embodiment, the alloy has a hardness of at least 300 Vickers (for example, after age-hardening). The gold alloy includes at least one of 0.5-2 wt% Co, 0.1-0.5 wt% Ir, and 0.1-0.5 wt% Ru. In some embodiments, the gold alloy includes at least one of 1 wt% Co, 0.2 wt% Ir, and 0.1 wt% Ru. The gold alloy includes 12.7-14.7 wt% Ag, 9.3-11.3 wt% Cu, and 0.5-2 wt% Pd.

Additional embodiments and features are set forth in part in the description that follows, and in part will become apparent to those skilled in the art upon examination of the specification, or may be learned by the practice of the embodiments discussed herein. A further understanding of the nature and advantages of certain embodiments may be realized by reference to the remaining portions of the specification, which forms a part of this disclosure.

### DETAILED DESCRIPTION

The disclosure may be understood by reference to the following detailed description. However, the gold alloy of the present invention has the composition as given in claim 1. In some aspects, the disclosure provides gold alloys with improved yield strength and improved hardness. The gold alloys can have mean equiaxed crystals of less than 40 microns in length. In further embodiments, the gold alloys can have mean equiaxed crystals of less than 30 microns in length. Such alloys are more resistant to cracking because of the grain sizes.

The gold alloys can be designed to be age hardened to have a hardness of at least 280 Vickers. In some instances, the gold alloys can be age hardened to have a hardness of at least 290 Vickers. In some embodiments, the alloys can also be designed to have a hardness of 300 Vickers. In some embodiments, the alloys can also be designed to have a hardness between 300 and 400 Vickers. With such an improved hardness, the gold alloys can have very good scratch resistance and improved durability for use as enclosures for electronic devices. The gold alloys still have the appealing color, such as yellow gold or rose gold, or any designed gold color. The alloys can also have good surface finish after polishing.

The alloys may include gold (Au) and silver (Ag). The alloys also include copper (Cu). The gold alloys also include cobalt (Co), which can form Co-rich precipitates or second phase particles to strengthen the alloys. Co may also help refine the grains to strengthen the gold alloys. The gold alloys may also include iridium (Ir) or ruthenium (Ru) to refine grain size to strengthen the alloys.

In various embodiments describing the wt% of the alloys in terms of various quantities of elements, the balance of the alloy can include Au and incidental impurities. Further, various amounts of elements in each alloy are described herein. It will be understood that the amounts can be combined into the alloys described herein in any order.

The alloys further include palladium (Pd) as a bleaching element in yellow gold alloys and rose gold alloys.

It will be appreciated by those skilled in the art that one may vary the alloy compositions to match to any gold colors, for example, 1N, 2N, 3N, 4N or 5N. In various aspects, the Au-Ag-Cu alloys have different compositions matched to a common yellow gold and a pink gold color.

In some embodiments, Au-Ag-Cu alloys do not include other elements, such as Zn, Al, Mn, and Ni. The presence of these elements may be limited by the impurity level of the alloys.

Various amounts of elements in each alloy are described herein. It will be understood that the amounts can be combined into the alloys described herein in any order.

In some embodiments, the alloys have Ag less than 14.7 wt%. In some embodiments, the alloys have Ag less than 14.6 wt%. In some embodiments, the alloys have Ag less than 14.5 wt%. In some embodiments, the alloys have Ag less than 14.4 wt%. In some embodiments, the alloys have Ag less than 14.3 wt%. In some embodiments, the alloys have Ag less than 14.2 wt%. In some embodiments, the alloys have Ag less than 14.1 wt%. In some embodiments, the alloys have Ag less than 14.0 wt%. In some embodiments, the alloys have Ag less than 13.9 wt%. In some embodiments, the alloys have Ag less than 13.8 wt%. In some embodiments, the alloys have Ag less than 13.7 wt%. In some embodiments, the alloys have Ag less than 13.6 wt%. In some embodiments, the alloys have Ag less than 13.5 wt%. In some embodiments, the alloys have Ag less than 13.4 wt%. In some embodiments, the alloys have Ag less than 13.3 wt%. In some embodiments, the alloys have Ag less than 13.2 wt%. In some embodiments, the alloys have Ag less than 13.1 wt%. In some embodiments, the alloys have Ag less than 13.0 wt%. In some embodiments, the alloys have Ag less than 12.9 wt%. In some embodiments, the alloys have Ag less than 12.8 wt%.

In some embodiments, the alloys have Ag greater than 14.6 wt%. In some embodiments, the alloys have Ag greater than 14.5 wt%. In some embodiments, the alloys have Ag greater than 14.4 wt%. In some embodiments, the alloys have Ag greater than 14.3 wt%. In some embodiments, the alloys have Ag greater than 14.2 wt%. In some embodiments, the alloys have Ag greater than 14.1 wt%. In some embodiments, the alloys have Ag greater than 14.0 wt%. In some embodiments, the alloys have Ag greater than 13.9 wt%. In some embodiments, the alloys have Ag greater than 13.8 wt%. In some embodiments, the alloys have Ag greater than 13.7 wt%. In some embodiments, the alloys have Ag greater than 13.6 wt%. In some embodiments, the alloys have Ag greater than 13.5 wt%. In some embodiments, the alloys have Ag greater than 13.4 wt%. In some embodiments, the alloys have Ag greater than 13.3 wt%. In some embodiments, the alloys have Ag greater than 13.2 wt%. In some embodiments, the alloys have Ag greater than 13.1 wt%. In some embodiments, the alloys have Ag greater than 13.0 wt%. In some embodiments, the alloys have Ag greater than 12.9 wt%. In some embodiments, the alloys have Ag greater than 12.8 wt%. In some embodiments, the alloys have Ag greater than 12.7 wt%.

In some embodiments, the alloys have Cu less than 11.3 wt%. In some embodiments, the alloys have Cu less than 11.2 wt%. In some embodiments, the alloys have Cu less than 11.1 wt%. In some embodiments, the alloys have Cu less than 11.0 wt%. In some embodiments, the alloys have Cu less than 10.9 wt%. In some embodiments, the alloys have Cu less than 10.8 wt%. In some embodiments, the alloys have Cu less than 10.7 wt%. In some embodiments, the alloys have Cu less than 10.6 wt%. In some embodiments, the alloys have Cu less than 10.5 wt%. In some embodiments, the alloys have Cu less than 10.4 wt%. In some embodiments, the alloys have Cu less than 10.3 wt%. In some embodiments, the alloys have Cu less than 10.2 wt%. In some embodiments, the alloys have Cu less than 10.1 wt%. In some embodiments, the alloys have Cu less than 10.0 wt%. In some embodiments, the alloys have Cu less than 9.9 wt%. In some embodiments, the alloys have Cu less than 9.8 wt%. In some embodiments, the alloys have Cu less than 9.7 wt%. In some embodiments, the alloys have Cu less than 9.6 wt%. In some embodiments, the alloys have Cu less than 9.5 wt%. In some embodiments, the alloys have Cu less than 9.4 wt%.

In some embodiments, the alloys have Cu greater than 11.2 wt%. In some embodiments, the alloys have Cu greater than 11.1 wt%. In some embodiments, the alloys have Cu greater than 11.0 wt%. In some embodiments, the alloys have Cu greater than 10.9 wt%. In some embodiments, the alloys have Cu greater than 10.8 wt%. In some embodiments, the alloys have Cu greater than 10.7 wt%. In some embodiments, the alloys have Cu greater than 10.6 wt%. In some embodiments, the alloys have Cu greater than 10.5 wt%. In some embodiments, the alloys have Cu greater than 10.4 wt%. In some embodiments, the alloys have Cu greater than 10.3 wt%. In some embodiments, the alloys have Cu greater than 10.2 wt%. In some embodiments, the alloys have Cu greater than 10.1 wt%. In some embodiments, the alloys have Cu greater than 10.0 wt%. In some embodiments, the alloys have Cu greater than 9.9 wt%. In some embodiments, the alloys have Cu greater than 9.8 wt%. In some embodiments, the alloys have Cu greater than 9.7 wt%. In some embodiments, the alloys have Cu greater than 9.6 wt%. In some embodiments, the alloys have Cu greater than 9.5 wt%. In some embodiments, the alloys have Cu greater than 9.4 wt%. In some embodiments, the alloys have Cu greater than 9.3 wt%.

In some embodiments, the alloys have Co less than 2.0 wt%. In some embodiments, the alloys have Co less than 1.8 wt%. In some embodiments, the alloys have Co less than 1.6 wt%. In some embodiments, the alloys have Co less than 1.4 wt%. In some embodiments, the alloys have Co less than 1.2 wt%. In some embodiments, the alloys have Co less than 1.0 wt%. In some embodiments, the alloys have Co less than 0.9 wt%. In some embodiments, the alloys have Co less than 0.8 wt%. In some embodiments, the alloys have Co less than 0.7 wt%. In some embodiments, the alloys have Co less than 0.6 wt%.

In some embodiments, the alloys have Co greater than 1.8 wt%. In some embodiments, the alloys have Co greater than 1.6 wt%. In some embodiments, the alloys have Co greater than 1.4 wt%. In some embodiments, the alloys have Co greater than 1.2 wt%. In some embodiments, the alloys have Co greater than 1.0 wt%. In some embodiments, the alloys have Co greater than 0.9 wt%. In some embodiments, the alloys have Co greater than 0.8 wt%. In some embodiments, the alloys have Co greater than 0.7 wt%. In some embodiments, the alloys have Co greater than 0.6 wt%. In some embodiments, the alloys have Co greater than 0.5 wt%.

In some embodiments, the alloys have Ir less than 0.5 wt%. In some embodiments, the alloys have Ir less than 0.4 wt%. In some embodiments, the alloys have Ir less than 0.3 wt%. In some embodiments, the alloys have Ir less than 0.2 wt%.

In some embodiments, the alloys have Ir greater than 0.4 wt%. In some embodiments, the alloys have Ir greater than 0.3 wt%. In some embodiments, the alloys have Ru greater than 0.2 wt%. In some embodiments, the alloys have Ru greater than 0.1 wt%.

In some embodiments, the alloys have Ru greater than 0.4 wt%. In some embodiments, the alloys have Ru greater than 0.3 wt%. In some embodiments, the alloys have Ru greater than 0.2 wt%. In some embodiments, the alloys have Ru greater than 0.1 wt%.

In some embodiments, the alloys have Pd less than 2.0 wt%. In some embodiments, the alloys have Pd less than 1.9 wt%. In some embodiments, the alloys have Pd less than 1.8 wt%. In some embodiments, the alloys have Pd less than 1.7 wt%. In some embodiments, the alloys have Pd less than 1.6 wt%. In some embodiments, the alloys have Pd less than 1.5 wt%. In some embodiments, the alloys have Pd less than 1.4 wt%. In some embodiments, the alloys have Pd less than 1.3 wt%. In some embodiments, the alloys have Pd less than 1.2 wt%. In some embodiments, the alloys have Pd less than 1.1 wt%. In some embodiments, the alloys have Pd less than 1.0 wt%. In some embodiments, the alloys have Pd less than 0.9 wt%. In some embodiments, the alloys have Pd less than 0.8 wt%. In some embodiments, the alloys have Pd less than 0.7 wt%. In some embodiments, the alloys have Pd less than 0.6 wt%.

In some embodiments, the alloys have Pd greater than 1.9 wt%. In some embodiments, the alloys have Pd greater than 1.8 wt%. In some embodiments, the alloys have Pd greater than 1.7 wt%. In some embodiments, the alloys have Pd greater than 1.6 wt%. In some embodiments, the alloys have Pd greater than 1.5 wt%. In some embodiments, the alloys have Pd greater than 1.4 wt%. In some embodiments, the alloys have Pd greater than 1.3 wt%. In some embodiments, the alloys have Pd greater than 1.2 wt%. In some embodiments, the alloys have Pd greater than 1.1 wt%. In some embodiments, the alloys have Pd greater than 1.0 wt%. In some embodiments, the alloys have Pd greater than 0.9 wt%. In some embodiments, the alloys have Pd greater than 0.8 wt%. In some embodiments, the alloys have Pd greater than 0.7 wt%. In some embodiments, the alloys have Pd greater than 0.6 wt%. In some embodiments, the alloys have Pd greater than 0.5 wt%.

It will be understood by those skilled in the art that any element and percentage described above can be combined with any other element and percentage in any combination.

It will be appreciated by those skilled in the art that the alloys may vary in gold content, even for 18 karat gold. In some embodiments, the alloys may include Au less than 76 wt%.

In some embodiments, the alloys may include Au greater than 75%. In some embodiments, the alloys may include Au greater than 76 wt%.

It will be appreciated by those skilled in the art that the alloys may vary in gold content, such as 24K gold. Similarly approaches may be applied to refine the alloys with improved strengths and hardness.

In some embodiments, the alloys have a hardness greater than 280 Vickers. In some embodiments, the alloys have a hardness greater than 290 Vickers. In some embodiments, the alloys have a hardness greater than 300 Vickers. In some embodiments, the alloys have a hardness greater than 310 Vickers. In some embodiments, the alloys have a hardness greater than 320 Vickers. In some embodiments, the alloys have a hardness greater than 330 Vickers. In some embodiments, the alloys have a hardness greater than 340 Vickers. In some embodiments, the alloys have a hardness greater than 350 Vickers. In some embodiments, the alloys have a hardness greater than 360 Vickers. In some embodiments, the alloys have a hardness greater than 370 Vickers. In some embodiments, the alloys have a hardness greater than 380 Vickers. In some embodiments, the alloys have a hardness greater than 390 Vickers.

In some embodiments, the alloys have a hardness less than 400 Vickers. In some embodiments, the alloys have a hardness less than 390 Vickers. In some embodiments, the alloys have a hardness less than 380 Vickers. In some embodiments, the alloys have a hardness less than 370 Vickers. In some embodiments, the alloys have a hardness less than 360 Vickers. In some embodiments, the alloys have a hardness less than 350 Vickers. In some embodiments, the alloys have a hardness less than 340 Vickers. In some embodiments, the alloys have a hardness less than 330 Vickers. In some embodiments, the alloys have a hardness less than 320 Vickers. In some embodiments, the alloys have a hardness less than 310 Vickers. In some embodiments, the alloys have a hardness less than 300 Vickers. In some embodiments, the alloys have a hardness less than 290 Vickers.

The disclosure provides methods for preparing the alloys. The preparation can include (1) melting and casting, (2) homogenization, (3) rolling (4) recrystallization heat treatment, (5) cold working, and (6) aging. The disclosure also provides methods for evaluating the alloys, including analyzing microstructure (e.g. grain size, aspect ratio, precipitate composition by scanning electron microscope/energy dispersion spectroscopy (SEM/EDS), and micrographs after etching), measuring mechanical properties, such as hardness and tensile properties, and cosmetic evaluation including color evaluation etc. These measurements may be performed at each or some of the preparation steps (1)-(5).

The gold alloys can be first melted and cast. The as-cast gold alloys may form dendrites (in crystalline form). Alloys are typically cast at temperatures above 1000°C. In various embodiments, the microstructure of the gold alloys can have dendrites and composition gradients.

The as-cast gold alloys can be heat treated by homogenization at elevated temperature to eliminate the as-cast dendrites and to produce a single phase, which may have larger grains than that of the as-cast alloys. Homogenization also causes elements to be more uniformly distributed, improving the hardness characteristics of the alloy. The homogenization temperatures can be at a temperature below the melting temperature of the alloy such that it does not melt or promote large grain growth, while at a temperature high enough to eliminate dendrites.

In various embodiments the homogenization temperature is less than 950°C. In some embodiments, the homogenization temperature is less than 900°C. In some embodiments, the homogenization temperature is less than 850°C. In some embodiments, the homogenization temperature is less than 800°C. In some embodiments, the homogenization temperature is less than 750°C. In some embodiments, the homogenization temperature is less than 700°C. In some embodiments, the homogenization temperature is greater than 550°C. In some embodiments, the homogenization temperature is greater than 600°C. In some embodiments, the homogenization temperature is about 650°C. In some embodiments, the homogenization temperature is in a range from 625°C to 675°C. In various embodiments, the grain sizes are greater than 100 microns, and in some cases greater than 500 microns. Rose gold after homogenization shows grains greater than 500 microns, and yellow gold shows some grains after homogenization to be greater than 500 microns.

Following the homogenization, the gold alloys may go through a rolling operation to form a sheet. In various embodiments, rolling can create internal energy to enable recrystallization of the alloy. In various embodiments, the sheet can be about 10 mm thick. The gold alloys may undergo cold work hardening, followed by solution heat treatments. In various aspects, the rolling operation can increase the hardness of the alloys.

The alloy can be recrystallized and heat treated to achieve finer equiaxed grain size. The grain size can have improved ductility, strength, and/or improved cosmetics. Small grains, e.g. equiaxed grains with an average length less than 40 microns, or alternatively 30 microns, can be formed by recrystallization.

In various embodiments, the recrystallization step is performed near the lowest temperature at which a homogenous structure can be formed for a particular alloy. In various embodiments, the temperature of recrystallization is selected such that the temperature is the lowest temperature that creates a homogenous structure. In some embodiments, the recrystallization temperature is greater than 450°C. In some embodiments, the recrystallization temperature is greater than 475°C. In some embodiments, the recrystallization temperature is greater than 500°C. In some embodiments, the recrystallization temperature is greater than 525°C. In some embodiments, the recrystallization temperature is less than 650°C. In some embodiments, the recrystallization temperature is less than 625°C. In some embodiments, the recrystallization temperature is less than 600°C. In some embodiments, the recrystallization temperature is less than 575°C.

In certain embodiments, the presence of grain refining particles, such as Co, Ir, or Ru, can maintain the fine, recrystallized grain size. Solution heat treatment can be performed at several temperatures for the alloys, such that the temperatures can be refined to produce the designed microstructure (e.g. grain sizes).

Further, after the solution heat treatment, the gold alloys may be cold worked to reduce the cross-sectional area by about 90% to produce sheets about 1 mm thick. The gold alloys can then be aged to form precipitates to strengthen the alloys. The precipitates may be within the grains and/or along the grain boundaries.

In various embodiments, the alloys have equiaxed grains. Further, in various embodiments the grains are less than 40 microns, or alternatively 30 microns. Alloys having smaller grains show improved resistance to cracking.

In some embodiments, evaluation methods include tensile tests, hardness measurements, and cosmetic evaluations including color and surface finish evaluations.

Tensile tests can be performed after preparations (3) rolling and solution heat treatment, (4) cold working, and (6) alloy with peak hardness after aging. Yield strengths of the alloys may be determined per ASTM E8, which covers the testing apparatus, test specimens, and testing procedure for tensile testing.

Hardness tests can be performed after preparations (1) as-cast, (2) after homogenization, (3) rolling and solution heat treatment, (4) cold working, and (5) after aging. The Vickers hardness can be measured using a Vickers microhardness tester.

Standard methods can be used to evaluate cosmetic appeal including color, gloss, and haze. The color of objects may be determined by the wavelength of light that is reflected or transmitted without being absorbed, assuming incident light is white light. The visual appearance of objects may vary with light reflection or transmission. Additional appearance attributes may be based on the directional brightness distribution of reflected light or transmitted light, commonly referred to glossy, shiny, dull, clear, and haze, among others. The quantitative evaluation may be performed based on ASTM Standards on Color & Appearance Measurement, ASTM E-430 Standard Test Methods for Measurement of Gloss of High-Gloss Surfaces, including ASTM D523 (Gloss), ASTM D2457 (Gloss on plastics), ASTM E430 (Gloss on high-gloss surfaces, haze), and ASTM D5767 (DOI), among others. The measurements of gloss, haze, and DOI may be performed by testing equipment, such as Rhopoint IQ.

Color evaluation by brightness (*L**), *a** (between red and green) and *b** (between blue and yellow) can be performed for the alloy with peak hardness after aging. For example, high *b** values suggest an unappealing yellowish color, not a gold yellow color. Nearly zero parameters *a** and *b** suggest a neutral color. Low L*** values suggest dark brightness, while high *L** values suggest great brightness. For color measurement, testing equipment, such as X-Rite ColorEye XTH andX-Rite Coloreye 7000, may be used. These measurements are according to CIE/ISO standards for illuminants, observers, and the *L** *a** *b** color scale. For example, the standards include: (a) ISO 11664-1:2007(E)/CIE S 014-1/E:2006: Joint ISO/CIE Standard: Colorimetry-Part 1: CIE Standard Colorimetric Observers; (b) ISO 11664-2:2007(E)/CIE S 014-2/E:2006: Joint ISO/CIE Standard: Colorimetry-Part 2: CIE Standard Illuminants for Colorimetry, (c) ISO 11664-3:2012(E)/CIE S 014-3/E:2011: Joint ISO/CIE Standard: Colorimetry-Part 3: CIE Tristimulus Values; and (d) ISO 11664-4:2008(E)/CIE S 014-4/E:2007: Joint ISO/CIE Standard: Colorimetry-Part 4: CIE 1976 *L*a***b** Colour Space.

In various aspects, rose gold has a brightness *L** greater than 80. In further variations, the rose gold has a brightness *L** greater than 85. In further variations, the rose gold can have a brightness *L** from 85 to 90.

In various aspects, rose gold has an a* value greater than 3. In various aspects, rose gold has an a* value greater than 4. In various aspects, rose gold has an a* value greater than 4. In various aspects, rose gold has an a* value greater than 5. In various aspects, rose gold has the a* value less than 16. In various aspects, rose gold has an a* value less than 13. In various aspects, rose gold has an a* value less than 10. In certain embodiments, rose gold has an a* value from 5 to 10.

In various aspects, rose gold has the b* value greater than 10. In various aspects, rose gold has a b* value greater than 13. In various aspects, rose gold has a b* value greater than 16. In various aspects, rose gold has a b* value less than 27. In various aspects, rose gold has a b* value less than 24. In various aspects, rose gold has a b* value less than 21. In various aspects, rose gold has a b* value from 16 to 21.

In various aspects, yellow gold has a brightness *L** greater than 85. In further variations, the yellow gold has a brightness *L** greater than 89. In further variations, the yellow gold has a brightness L from 89 to 94.

In various aspects, yellow gold has a a* value greater than 1. In various aspects, yellow gold has an a* value less than 12. In various aspects, yellow gold has a a* value less than 9. In various aspects, yellow gold has a a* value less than 6. In various aspects, yellow gold has a a* value from 1 to 6.

In various aspects, yellow gold has a b* value greater than 20. In various aspects, yellow gold has an a* value greater than 23. In various aspects, yellow gold has a b* value greater than 25. In various aspects, yellow gold has a b* value less than 35. In various aspects, yellow gold has a b* value less than 33. In various aspects, yellow gold has a b* value less than 30. In certain embodiments, yellow gold has a b* value from 25 to 30.

### Examples

The following examples describe alloys disclosed herein. It will be appreciated by those skilled in the art that many modifications, both to materials and methods, may be practiced without departing from the scope of the disclosure. However, only Alloy 4 falls within the ambit of the invention, the remaining examples fall outside the scope of the invention.

Alloys 1-4 include Au-Ag-Cu-Pd and target a yellow gold color approximately equal to IN. Alloys 2-4 include at least one of the strengthening alloy elements, Co, Ir, or Ru, added to base alloy 1. Alloys 5-6 can include Au-Ag-Cu and target a rose gold color approximately equal to 5N. Alloys can include at least one of strengthening alloy elements, Co, Ir, or Ru, added to base alloy 5.

### Example 1

Alloy 1 referred to in Table 1 is designed to have a similar color to that of 14 K yellow gold such that the color of the alloys 1-4 is approximately equal to IN, which is a lighter yellow gold color than that disclosed in Provisional Patent Application No. 61/876,163. Alloy 1 may have 75-79 wt% Au, 12.7-14.7 wt% Ag, 9.3-11.3 wt% Cu, and 0.5-2 wt% palladium (Pd), which determines the base color of the gold alloy. Pd is a whitening alloy element to lighten the color for the alloy 1. The ratio of Ag to Cu of the alloy 1 is selected to be close to that of 14 K gold 1N, which includes 58.5 wt% Au, 25.0. wt% Ag, and 16.5 wt% Cu.

In a particular embodiment, example gold alloy 1 includes 75 wt% Au, 13.7 wt% Ag, 10.3 wt% Cu, and 1.0 wt% Pd. This alloy 1 is used as a baseline or reference for the alloys with improved strengths, such as alloys 2-4 as described below.

### Example 2

Alloy 2 referred to in Table 1 can be strengthened by adding a small trace of Co, ranging from 0.5 to 2%, to alloy 1. Although more Co may help strengthen the alloy, the upper range of Co of alloy 2 is limited by minimizing the color deviation from the base alloy 1. Alloy 2 adjusts Ag, Cu, and Pd proportionally to slightly lower amounts compared to alloy 1, due to the addition of Co, which has a slight bleaching effect like Pd.

Co can form Co-rich precipitates or Co-rich FCC particles in the alloys to strengthen the alloys. Co may also help refine the grains. In some examples, alloy 2 may have 75-79 wt% Au, 12.1-14.1 wt% Ag, 8.95-10.95 wt% Cu, 0.5-2 wt% palladium (Pd), and 0.5-2.0 wt% Co. In a particular example, example gold alloy 2 includes 75 wt% Au, 13.1 wt% Ag, 9.95 wt% Cu, 0.95 wt% Pd, and 1.0 wt% Co.

### Example 3

Alloy 3 referred to in Table 1 can be strengthened by adding a small trace of Ru ranging from 0.1 to 0.5%. Ru may form second phase particles or inclusions in the alloys to refine the grain size, which strengthens the alloys. The gold alloys cannot include too much Ru, which may affect the alloy cosmetics after polishing. Specifically, the pull-out of Ru inclusions on the surface after polishing can affect surface finish. Alternatively, an alloy can be strengthened by adding a small trace of Ir ranging from 0.1 to 0.5%, instead of Ru. Ir is chemically similar to Ru.

In some examples, alloy 3 may have 75-79 wt% Au, 12.6-14.6 wt% Ag, 9.2-11.2 wt% Cu, 0.5-2 wt% palladium (Pd), and 0.1-0.5 wt% Ir or Ru. In another particular example, example gold alloy 3 includes 75 wt% Au, 13.65 wt% Ag, 10.25 wt% Cu, 1.0 wt% Pd, and 0.1 wt% Ru.

### Example 4

Alloy 4 referred to in Table 1 may be strengthened by forming Co rich precipitates and by refining grains by alloying Ir or Ru to alloy 1. In some embodiments, the gold alloys include Co to form precipitates to strengthen the alloys. The gold alloys also include Ir to refine the grain structure and thus to strengthen the alloys.

In some embodiments, alloy 4 may have 75-79 wt% Au, 12.0-14.0 wt% Ag, 8.85-10.85 wt% Cu, 0.5-2 wt% Pd, 0.5-2.0 wt% Co, and 0.1-0.5 wt% Ir or Ru. In a particular embodiment, example gold alloy 4 includes 75 wt% Au, 13.0 wt% Ag, 9.85 wt% Cu, 0.95 wt% Pd, 1.0 wt% Co, and 0.2 wt% Ir.

### Example 5

In some embodiments, the gold alloys can have a different gold color, for example, rose gold color 5N. In some examples, alloy 5 includes 75-79 wt% Au, 4-6 wt% Ag, and 19-21 wt% Cu. In a particular example, example gold alloy 5 referred to in Table 2 includes 75 wt% Au, 5 wt% Ag, and 20 wt% Cu. This rose gold alloy 5 is used as a baseline or reference for rose gold alloy 6.

### Example 6

Alloy 6 referred to in Table 2 is strengthened by adding a small trace of Co to alloy 5. In various embodiments, the Co forms precipitates to strengthen the alloy. Example gold alloy 6 can be designed to have similar color to alloy 5, but to have improved strength. Cu and Ag wt% of alloy 6 are adjusted proportionally to slightly lower amounts compared to that of the alloy 5, while Au wt% of alloy 6 remains the same as that of the alloy 5. The color of alloy 6 is mainly determined by the relative ratios of Ag and Cu. In some examples, alloy 6 may include 75-79 wt% Au, 3.8-5.8 wt% Ag, 18.2-20.2 wt% Cu, and 0.5 to 2.0 wt% Co. In a particular example, alloy 6 includes 75 wt% Au, 4.8 wt% Ag, 19.2 wt% Cu, and 1.0 wt% Co.

### Example 7

Alloy 9 referred to in Table 1 includes Au, Cu, and Ag. In some embodiments, the alloy includes 75-79 wt% Au, 11-13 wt% Ag, and 11-14 wt% Cu. In a further embodiment, the alloy includes 75-79 wt% Au, 12-13 wt% Ag, and 12-13% wt% Cu. In a further embodiment, the alloy includes 75 wt% Au, 12.3 wt% Ag, and 12.7 wt% Cu. In some embodiments, the yellow gold alloy has a hardness of at least 280 Vickers. In another embodiment, the yellow gold has a hardness of at least 290 Vickers.

### Example 8

In various examples, the alloy is a rose gold alloy. The rose gold alloy includes 75-79 wt% Au, 20-25 wt% Cu, and 1-3 wt% Pd. In a further example, the alloy includes 75-79 wt% Au, 20-25 wt% Cu, and 1-3 wt% Pd. In another example, the alloy includes 75 wt% Au, 23 wt% Cu, and 2 wt% Pd. In some examples, the rose gold alloy has a hardness of at least 330 Vickers. In another example, the rose gold has a hardness of at least 340 Vickers. Tables 1-12 list the characterization of gold alloys 1-6, 9, and 10 after each of the preparation operations of (1) melting and casting, (2) homogenization, (3) rolling and solution heat treatment, (4) cold working, and (5) aging.

**Table 1 Characterization of the as-cast microstructure of yellow gold alloys**

| | Alloy 1 (yellow gold) | Alloy 2 (high strength yellow gold) | Alloy 3 (high strength yellow gold) | Alloy 4 (high strength yellow gold) | Alloy 9 (high strength yellow gold) |
|---|---|---|---|---|---|
| Composition (wt%) | 75.0 Au | 75 Au | 75.0 Au | 75.0 Au | 75.0 Au |
| | 13.7 Ag | 13.1 Ag | 13.6 Ag | 13 Ag | 12.3 Ag |
| | 10.3 Cu | 9.95 Cu | 10.2 Cu | 9.85 Cu | 12.7 Cu |
| | 1 Pd | 0.95 Pd | 1 Pd | 0.95 Pd | |
| | | 1 Co | 0.1 Ru | 1 Co | |
| | | | | 0.2 Ir | |

**Table 2 Characterization of alloy microstructure after homogenization**

| | Alloy 1 (yellow gold) | Alloy 2 (high strength yellow gold) | Alloy 3 (high strength yellow gold) | Alloy 4 (high strength yellow gold) | Alloy 9 (high strength yellow gold) |
|---|---|---|---|---|---|
| Composition (wt%) | 75.0 Au | 75 Au | 75.0 Au | 75.0 Au | 75.0 Au |
| | 13.7 Ag | 13.1 Ag | 13.6 Ag | 13 Ag | 12.3 Ag |
| | 10.3 Cu | 9.95 Cu | 10.2 Cu | 9.85 Cu | 12.7 Cu |
| | 1 Pd | 0.95 Pd | 1 Pd | 0.95 Pd | |
| | | 1 Co | 0.1 Ru | 1 Co | |
| | | | | 0.2 Ir | |
| Homogenization | • 650°C, 60 mins (WQ) | • 850°C, 60 mins (WQ) | • 850°C, 60 mins (WQ) | • 850°C, 30 mins (WQ) | • |
| | • | • | | | |

**Table 3 Characterization of alloy microstructure after rolling and solution heat treatment**

| | Alloy 1 (yellow gold) | Alloy 2 (high strength yellow gold) | Alloy 3 (high strength yellow gold) | Alloy 4 (high strength yellow gold) | Alloy 9 (high strength yellow gold) |
|---|---|---|---|---|---|
| Composition (wt%) | 75.0 Au | 75 Au | 75.0 Au | 75.0 Au | 75.0 Au |
| | 13.7 Ag | 13.1 Ag | 13.6 Ag | 13 Ag | 12.3 Ag |
| | 10.3 Cu | 9.95 Cu | 10.2 Cu | 9.85 Cu | 12.7 Cu |
| | 1 Pd | 0.95 Pd | 1 Pd | 0.95 Pd | |
| | | 1 Co | 0.1 Ru | 1 Co | |
| | | | | 0.2 Ir | |
| Rolling | 75-80% reduction | 75-80% reduction | 75-80% reduction | 75-80% reduction | 50% reduction |
| Solution heat treatment (vacuum) | 550°C, 30 mins (WQ) | • 850°C, 60 mins (WQ) | • 650°C, 30 mins (WQ) | • 850°C, 60 mins (WQ) | • 550°C, 60 mins (WQ) |
| | | | | | • |
| Grain size after solution heat treatment | Less than 30 microns. | • Less than 30 microns. | • Less than 30 microns. | • Less than 30 microns. | • Less than 30 microns. |
| | | | • | | |

**Table 4 Characterization of the microstructure after cold working**

| | Alloy 1 (yellow gold) | Alloy 2 (high strength yellow gold) | Alloy 3 (high strength yellow gold) | Alloy 4 (high strength yellow gold) | Alloy 9 (high strength yellow gold) |
|---|---|---|---|---|---|
| Composition (wt%) | 75.0 Au | 75 Au | 75.0 Au | 75.0 Au | 75.0 Au |
| | 13.7 Ag | 13.1 Ag | 13.6 Ag | 13 Ag | 12.3 Ag |
| | 10.3 Cu | 9.95 Cu | 10.2 Cu | 9.85 Cu | 12.7 Cu |
| | 1 Pd | 0.95 Pd | 1 Pd | 0.95 Pd | |
| | | 1 Co | 0.1 Ru | 1 Co | |
| | | | | 0.2 Ir | |
| Cold Work Reduction of Area | 90% | 90% | 90% | 90% | 60% |

**Table 5 Characterization of alloy microstructure after aging**

| | Alloy 1 (yellow gold) | Alloy 2 (high strength yellow gold) | Alloy 3 (high strength yellow gold) | Alloy 4 (high strength yellow gold) | Alloy 9 (high strength yellow gold) |
|---|---|---|---|---|---|
| Composition | 75.0 Au | 75 Au | 75.0 Au | 75.0 Au | 75.0 Au |
| (wt%) | 13.7 Ag | 13.1 Ag | 13.6 Ag | 13 Ag | 12.3 Ag |
| | 10.3 Cu | 9.95 Cu | 10.2 Cu | 9.85 Cu | 12.7 Cu |
| | 1 Pd | 0.95 Pd | 1 Pd | 0.95 Pd | |
| | | 1 Co | 0.1 Ru | 1 Co | |
| | | | | 0.2 Ir | |
| Aging in vacuum | • 300°C, 8 hrs, Air cooled | • | • 300°C, 8 hrs, air cooled | • 300°C, 8 hrs, air cooled | • 300°C, 1 hr, air cool |
| | | • 300°C, 8 hrs, air cooled | | | |
| Hardness (Hv) | 312 | 322 | 306 | 317 | |

**Table 6 Report of alloys having peak hardness after aging**

| | Alloy 1 (yellow gold) | Alloy 2 (high strength yellow gold) | Alloy 3 (high strength yellow gold) | Alloy 4 (high strength yellow gold) | Alloy 9 (high strength yellow gold) |
|---|---|---|---|---|---|
| Composition (wt%) | 75.0 Au | 75 Au | 75.0 Au | 75.0 Au | 75.0 Au |
| | 13.7 Ag | 13.1 Ag | 13.6 Ag | 13 Ag | 12.3 Ag |
| | 10.3 Cu | 9.95 Cu | 10.2 Cu | 9.85 Cu | 12.7 Cu |
| | 1 Pd | 0.95 Pd | 1 Pd | 0.95 Pd | |
| | | 1 Co | 0.1 Ru | 1 Co | |
| | | | | 0.2 Ir | |
| Tensile Strength (MPa) | 993 | 1003 | 974 | 1012 | |

**Table 7 Characterization of the as-cast microstructure of rose gold alloys**

| | Alloy 5 (rose gold 5N) | Alloy 6 (high strength rose gold) | Alloy 10 (high strength rose gold) | Alloy 11 (rose gold) |
|---|---|---|---|---|
| Composition (wt%) | 75.0 Au | 75.0 Au | 75.0 Au | 75.3 Au |
| | 5 Ag | 4.8 Ag | 23 Cu | 23. Cu |
| | 20 Cu | 19.2 Cu | 2 Pd | 1.5 Ag |
| | | 1 Co | | 0.2 Pd |

**Table 8 Characterization of alloy microstructure after homogenization**

| | Alloy 5 (rose gold 5N) | Alloy 6 (high strength rose gold) | Alloy 10 (high strength rose gold) | Alloy 11 (rose gold) |
|---|---|---|---|---|
| Composition (wt%) | 75.0 Au | 75.0 Au | 75.0 Au | 75.3 Au |
| | 5 Ag | 4.8 Ag | 23 Cu | 23. Cu |
| | 20 Cu | 19.2 Cu | 2 Pd | 1.5 Ag |
| | | 1 Co | | 0.2 Pd |
| Homogenization | • 650°C, 30 mins (WQ) | • 850°C, 60 mins (WQ) | • 550°C, 30 mins (WQ) | |

**Table 9 Characterization of the microstructure after rolling and solution heat treatment**

| | Alloy 5 (rose gold 5N) | Alloy 6 (high strength rose gold) | Alloy 10 (high strength rose gold) | Alloy 11 (rose gold) |
|---|---|---|---|---|
| Composition (wt%) | 75.0 Au | 75.0 Au | 75.0 Au | 75.3 Au |
| | 5 Ag | 4.8 Ag | 23 Cu | 23. Cu |
| | 20 Cu | 19.2 Cu | 2 Pd | 1.5 Ag |
| | | 1 Co | | 0.2 Pd |
| Rolling | 75-80% reduction | 75-80% reduction | 50% reduction | |
| Solution heat treatment (vacuum) | • 450°C, 30 mins (WQ) | • 850°C, 30 mins (WQ) | • 550°C, 30 mins (WQ) | |

**Table 10 Characterization of alloy microstructure after cold working**

| | Alloy 5 (rose gold 5N) | Alloy 6 (high strength rose gold) | Alloy 10 (high strength rose gold) | Alloy 11 (rose gold) |
|---|---|---|---|---|
| Composition (wt%) | 75.0 Au | 75.0 Au | 75.0 Au | 75.3 Au |
| | 5 Ag | 4.8 Ag | 23 Cu | 23. Cu |
| | 20 Cu | 19.2 Cu | 2 Pd | 1.5 Ag |
| | | 1 Co | | 0.2 Pd |
| Cold Work Reduction of Area | 90% | 90% | 60% | |

**Table 11 Characterization of alloy microstructure after aging**

| | Alloy 5 (rose gold 5N) | Alloy 6 (high strength rose gold) | Alloy 10 (high strength rose gold) | Alloy 11 (rose gold) |
|---|---|---|---|---|
| Composition (wt%) | 75.0 Au | 75.0 Au | 75.0 Au | 75.3 Au |
| | 5 Ag | 4.8 Ag | 23 Cu | 23. Cu |
| | 20 Cu | 19.2 Cu | 2 Pd | 1.5 Ag |
| | | 1 Co | | 0.2 Pd |
| Aging in vacuum | • 300°C, 1 hr, WQ • | • 300°C, 8 hrs, WQ | • 300°C, 1 hr, WQ | • |
| Hardness (Hv) | 393 | 388 | 351 | |

**Table 12 Report of alloys having peak hardness after aging**

| | Alloy 5 (rose gold 5N) | Alloy 6 (high strength rose gold) | Alloy 10 (high strength rose gold) | Alloy 11 (rose gold) |
|---|---|---|---|---|
| Composition (wt%) | 75.0 Au | 75.0 Au | 75.0 Au | 75.3 Au |
| | 5 Ag | 4.8 Ag | 23 Cu | 23. Cu |
| | 20 Cu | 19.2 Cu | 2 Pd | 1.5 Ag |
| | | 1 Co | | 0.2 Pd |
| Tensile Strength (MPa) | 1141 | 1237 | | |

As depicted in Tables 1-12, microhardness is measured after each of preparations (1)-(5) as described above. Microhardness measurements may be performed at a number of times, such as at least five times, and then an average hardness may be obtained.

Microstructure can also be characterized after each of preparations (1)-(5) as described above. For example, grain size can be measured and aspect ratio of the grains can be characterized for the alloy with the highest hardness.

Example homogenization temperatures for alloys 2-4 and 6 are higher than that of alloy 1 and alloy 5. When the homogenization temperature is higher, it is easier to form a single phase, however the grains may also grow larger with higher temperatures.

It will be appreciated by those skilled in the art that other temperatures and times for the homogenization may be used in various embodiments. In some embodiments, the homogenization temperatures may be at an elevated temperature, such as 850°C for alloys 2-4 and 6. In some embodiments, the homogenization temperature may be not be elevated, for example 650°C for alloys 9 and 10.

Example solution treatment temperature for alloys 2-4 and 6 can be higher than that of base alloy 1 and base alloy 5. In various embodiments, these temperatures are greater than 800°C and less than 900°C. In various embodiments, alloys 2-4 and 6 can be strengthened by adding Co and/or Ir to form second phase particles. When the solution treatment temperature is higher, it is easier to form a single phase, however the grains may also grow larger with higher temperatures. An alloy with small or fine grains generally has higher strength than the same type of alloy with larger grains. When the alloy has precipitates with pinning grains, the grains may not grow fast compared to the alloy without precipitates, such that higher solution treatment temperature can be used for the alloy with precipitates.

Without wishing to be held to any theory or mechanism of action, by controlling the temperature of recrystallization heat treatment to be at or close to the lowest temperature at which the a homogenous structure can be formed for a particular alloy, the alloy can be recrystallized by forming equiaxed grains having an average length of less than 40 microns or less than 30 microns. The resulting alloy has improved resistance to cracking than alloys with larger grains.

It will be appreciated by those skilled in the art that other temperatures and times for the solution heat treatments may be used in various embodiments. In some embodiments, the solution heat treatment temperatures may be greater than an elevated temperature, such as 850°C for alloys 2-4 and 6. In some embodiments, the solution heat treatment temperatures may be lower than an elevated temperature, such as 650°C for alloys 2-4 and 6. In some embodiments, the solution heat treatment temperatures may be greater than an elevated temperature, such as 650°C for alloys 1 and 5. In some embodiments, the solution heat treatment temperatures may be lower than an elevated temperature, such as 450°C for alloys 1 and 5.

In some embodiments, example aging temperatures remain the same for alloys 1-6 and 9-10. Example aging times vary from 1 hour to 8 hours. Aging times can be as described in the above-referenced examples. It will be appreciated by those skilled in the art that other aging temperatures and times may be used in various embodiments.

Those skilled in the art will appreciate that the presently disclosed embodiments teach by way of example and not by limitation. Therefore, the matter contained in the above description should be interpreted as illustrative and not in a limiting sense. The following claims are intended to cover all generic and specific features described herein, as well as all statements of the scope of the method and system, which, as a matter of language, might be said to fall there between.

## Claims

1. A gold alloy comprising 12.7-14.7 wt% Ag, 9.3-11.3 wt% Cu, 0.5-2 wt% Co, 0.1-0.5 wt% Ir, 0.1-0.5 wt% Ru, 0.5-2 wt% Pd, with the balance being Au and incidental impurities and wherein the gold alloy has a hardness of at least 280 Vickers.

2. The gold alloy according to claim 1, wherein said alloy has a brightness L from 89 to 94, an a* value from 1-6, and a b* value from 25-30.

## Patentansprüche

1. Goldlegierung, umfassend 12.7 bis 14.7 Gew.% Ag, 9.3 bis 11.3 Gew.% Cu, 0.5 bis 2 Gew.% Co, 0.1 bis 0.5 Gew.% Ir, 0.1 bis 0.5 Gew.% Ru, 0.5 bis 2 Gew.% Pd, mit dem Rest Au und zufälligen Verunreinigungen, und wobei die Goldlegierung eine Härte von zumindest 280 Vickers aufweist.

2. Goldlegierung nach Anspruch 1, wobei die Legierung eine Helligkeit L von 89 bis 94, einen a*-Wert von 1 bis 6 und einen b*-Wert von 25 bis 30 aufweist.

## Revendications

1. Alliage d'or comprenant 12,7 à 14,7 % en poids d'Ag, 9,3 à 11,3 % en poids de Cu, 0,5 à 2 % en poids de Co, 0,1 à 0,5 % en poids d'Ir, 0,1 à 0,5 % en poids de Ru, 0,5 à 2 % en poids de Pd, le reste étant constitué d'Au et des impuretés inévitables, l'alliage d'or présentant une dureté d'au moins 280 Vickers.

2. Alliage d'or selon la revendication 1, ledit alliage présentant une luminosité L de 89 à 94, une valeur a* de 1 à 6 et une valeur b* de 25 à 30.
